(19) **Europäisches Patentamt**

**European Patent Office**

**Office européen des brevets**

(11) **EP 1 135 695 B1**

(12) **EUROPÄISCHE PATENTSCHRIFT**

(45) Veröffentlichungstag und Bekanntmachung des Hinweises auf die Patenterteilung:
**02.02.2005 Patentblatt 2005/05**

(51) Int Cl.$^7$: **G01R 33/09**

(21) Anmeldenummer: **00978958.7**

(22) Anmeldetag: **29.09.2000**

(86) Internationale Anmeldenummer:
**PCT/DE2000/003403**

(87) Internationale Veröffentlichungsnummer:
**WO 2001/025806 (12.04.2001 Gazette 2001/15)**

(54) **VERFAHREN UND SCHALTUNGSANORDNUNG ZUR FESTSTELLUNG EINER RICHTUNG EINES ÄUSSEREN MAGNETISCHEN FELDES**

METHOD AND CIRCUIT ARRANGEMENT FOR DETERMINING THE DIRECTION OF AN EXTERNAL MAGNETIC FIELD

PROCEDE ET CIRCUIT POUR DETERMINER LA DIRECTION D'UN CHAMP MAGNETIQUE EXTERIEUR

(84) Benannte Vertragsstaaten:
**DE FR GB IT SE**

(30) Priorität: **02.10.1999 DE 19947761**

(43) Veröffentlichungstag der Anmeldung:
**26.09.2001 Patentblatt 2001/39**

(73) Patentinhaber: **ROBERT BOSCH GMBH**
**70442 Stuttgart (DE)**

(72) Erfinder: **STEINLECHNER, Siegbert**
**71229 Leonberg (DE)**

(56) Entgegenhaltungen:
**US-A- 4 240 069       US-A- 4 995 165**
**US-A- 5 351 005**

**Beschreibung**

Die vorliegende Erfindung betrifft ein Verfahren und eine Schaltungsanordnung zur Feststellung einer Richtung eines äußeren magnetischen Feldes.

Die Verwendung magneto-resistiver Elemente im Rahmen von Winkelsensoren ist bekannt. Beispielsweise liefern Winkelsensoren auf der Grundlage des AMR-Effektes (Anisotropic Magneto-Resistence) Ausgangssignale, aus denen sich die Richtung eines außen angelegten Magnetfeldes bestimmen läßt. Ist der Winkel des Magnetfeldes relativ zum Sensor $\alpha$, so liefert der Sensor Ausgangssignale, die zu $\sin(2\alpha)$ bzw. $\cos(2x\alpha)$ proportional sind. In dieser Weise arbeitende AMR-Sensoren stellen, aufgrund der Periodizität der Sinus- und Cosinus-Signale einen Eindeutigkeitsbereich von 180° zur Verfügung. In einer Weiterentwicklung derartiger AMR-Sensoren, wie sie beispielsweise in der noch nicht veröffentlichten DE 198 39 446 offenbart ist, werden diese Sensoren mit integrierten Hilfsspulen ausgebildet.

Durch Anlegen eines entsprechenden Stromes an die Hilfsspulen werden in den jeweiligen Sensorhälften individuelle, geringe zusätzliche Magnetfelder erzeugt, die sich mit dem äußeren, zu messenden Magnetfeld überlagern und die Richtung des resultierenden Feldes verändern. Durch Beobachtung der Richtungsveränderung kann der Eindeutigkeitsbereich des Sensors von 180° auf 360° gesteigert werden.

Aufgabe der Erfindung ist es, eine möglichst einfache Ansteuerung und Auswertung eines einen Eindeutigkeitsbereich von 360° aufweisenden Winkelsensors zu gewährleisten.

Diese Aufgabe wird gelöst durch ein Verfahren zur Feststellung eines äußeren magnetischen Feldes B unter Verwendung eines magnetoresistiven Sensors mit folgenden Schritten:

- Überlagerung des äußeren Magnetfeldes B mit einem fluktuierenden Magnetfeld,
- Erzeugung eines vom Sinus und Cosinus des Winkels des äußeren Magnetfeldes bezüglich einer Referenzrichtung abhängigen ersten bzw. zweiten Signals unter Auskopplung oder Vernachlässigung jeweiliger vom fluktuierenden Magnetfeld abhängiger Signalanteile,
- Ermittlung eines dem Winkel des äußeren magnetischen Feldes bezüglich der Referenzrichtung zuordenbaren dritten Signals auf der Grundlage des ersten und des zweiten Signals, wobei dieses dritte Signal eine Periodizität von 180° aufweist,
- Ermittlung eines Korrektur-Logik-Signals unter Berücksichtigung der aus dem ersten bzw. zweiten Signal ausgekoppelten, vom fluktuierenden Magnetfeld abhängigen Signalanteils, welches für einen Winkel des äußeren Magnetfeldes B in einem ersten Winkelbereich, insbesondere zwischen 0 und 180°, einen ersten Pegel, und in einem zweiten Winkelbereich, insbesondere zwischen 180 und 360° einen zweiten Pegel einnimmt, und

- Ermittlung des tatsächlichen Winkels des Magnetfeldes B auf der Grundlage des Logik-Korrektursignals und des dritten Signals.

Erfindungsgemäß ist nun ein Ansteuer- und Auswerteverfahren für 360° AMR-Winkelsensoren zur Verfügung gestellt, welches störsicher ist und beispielsweise unabhängig von einer temperaturabhängigen Amplitude der Sensorsignale arbeitet. Zur Durchführung des Verfahrens werden keine festen Schwellwerte benötigt. Es läßt sich in einer elektronischen Schaltung kostengünstig realisieren. Die Messung der Wirkung des Stromes in der Hilfsspule, mittels derer das fluktuierende Magnetfeld erzeugt wird, erfolgt laufend im Hintergrund, ohne die Messung des unkorrigierten Winkels (d.h. des Winkels des zu messenden magnetischen Feldes) zu stören. Dadurch kann der Strom in der Hilfsspule gegenüber bekannten, Hilfsspulen verwendenden Lösungen sehr klein gehalten werden, wodurch herkömmlicherweise auftretende thermische Effekte im Sensor vermieden werden können. Ferner wird durch den geringen Spulenstrom die gesamte Verlustleistung gegenüber herkömmlichen Lösungen deutlich reduziert.

Vorteilhafte Ausgestaltungen des erfindungsgemäßen Verfahrens bzw. der erfindungsgemäßen Anordnung sind Gegenstand der Unteransprüche.

Gemäß einer bevorzugten Ausführungsform des erfindungsgemäßen Verfahrens werden zur Ermittlung des Korrektur-Logik-Signals zusätzlich das erste und zweite Signal, welches dem Sinus bzw. dem Cosinus des äußeren magnetischen Feldes zuordnenbar ist, berücksichtigt. Hierbei werden das erste und das zweite Signal jeweils Komparatoren zugeführt, welche durch Vergleich dieser Signale mit Schwellwerten Logiksignale erzeugen. Durch logische Verknüpfung der so erhaltenen Logik-Signale mit auf der Grundlage der ausgekoppelten Signalanteile erhaltenen Logik-Signalen ist das Korrektur-Logik-Signal in rechnerisch unaufwendiger Weise bereitstellbar.

Gemäß einer weiteren bevorzugten Ausgestaltung des erfindungsgemäßen Verfahrens wird zur Ermittlung des Korrektur-Logik-Signals ein weiteres Logiksignal verwendet, welches in Abhängigkeit von einem dem dritten Signal zuordnenbaren Winkel einen ersten oder einen zweiten Pegel einnimmt. Mit dieser Maßnahme kann auf zwei Komparatoren, wie sie bei Bereitstellung zweier Logik-Signale auf der Grundlage des ersten und zweiten Signals bereitgestellt werden müssen, verzichtet werden.

Zweckmäßigerweise nimmt dieses digitale Logik-Signal für einen Winkelbereich von 135 bis 180° den ersten Pegel, und einen Winkelbereich von 0 bis 135° des äußeren Magnetfeldes einen zweiten Pegel ein.

Die Aufgabe der Erfindung wird ferner gelöst durch eine Schaltungsanordnung mit den Merkmalen des Patentanspruchs 5. Diese Schaltungsanordnung ist relativ preiswert bereitstellbar und ermöglicht mit geringem Aufwand die Schaffung eines 360° -Winkelsensors unter Verwendung eines AMR-Sensors, welcher an sich lediglich einen Eindeutigkeitsbereich von 180° aufweist, und eines entsprechenden Logik-Korrektursignals.

Bevorzugte Ausführungsformen der Erfindung werden nun anhand der beigefügten Zeichnung im einzelnen erläutert. In dieser zeigt

Figur 1 eine erste bevorzugte Ausführungsform der erfindungsgemäßen Schaltungsanordnung,

Figur 2 eine zweite bevorzugte Ausführungsform der erfindungsgemäßen Schaltungsanordnung,

Figur 3 ein Schaubild zur Darstellung von bei Verwendung eines AMR-Sensors in Abhängigkeit von einem äußeren Magnetfeld erhaltenen cosinus- bzw. sinusförmigen Sensorsignale,

Figur 4 ein Schaubild zur Darstellung von Änderungen der Signale gemäß Figur 3 bei Modulation eines äußeren Feldes mit einem fluktuierenden weiteren magnetischen Feld,

Figur 5 ein Schaubild zur Darstellung im Rahmen der dargestellten Ausführungsform des erfindungsgemäßen Verfahrens erhaltener Digitalsignale, und

Figur 6 ein Schaubild zur Darstellung von mittels des erfindungsgemäßen Verfahrens bzw. der erfindungsgemäßen Schaltungsanordnung erhältlichen gemessenen Magnetfeldwinkels in Abhängigkeit von einem tatsächlichen Magnetfeldwinkel.

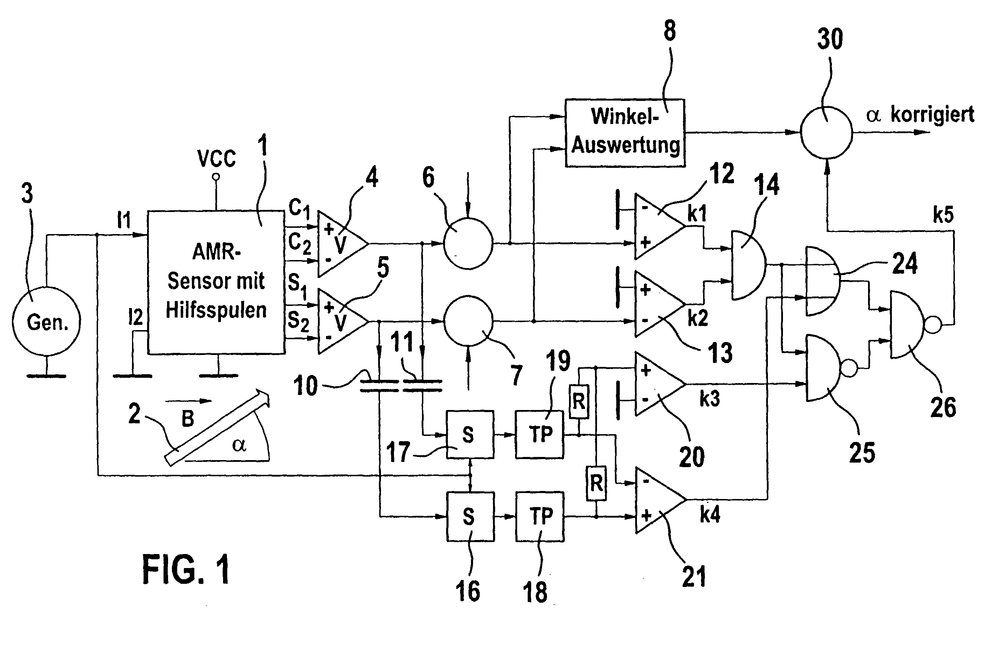

In Figur 1 ist mit 1 ein AMR-Sensor bezeichnet. Der AMR-Sensor 1-wird von einer Versorgungsspannung VCC beaufschlagt. Der AMR-Sensor 1 ist mit (nicht dargestellten) Hilfsspulen ausgebildet, wobei durch Anlegen eines Wechselstromes an diese Hilfsspulen fluktuierende Magnetfelder erzeugbar sind, die sich einem äußeren, zu messenden Feld überlagern. Die Richtung des äußeren, zu messenden Magnetfelds B ist mittels des Pfeiles 2 veranschaulicht. Im dargestellten (momentanen) Zustand weist das Magnetfeld B bezüglich einer Referenzrichtung einen Winkel $\alpha$ auf. Es sei angemerkt, daß das fluktuierende Magnetfeld bezüglich des äußeren Magnetfeldes klein ist.

Die Hilfsspulen werden über einen Generator 3 mit einer Wechselspannung gespeist, deren Frequenz typischerweise im kHz-Bereich liegt. In der Figur sind lediglich die Anschlüsse 11, 12 der Hilfsspule dargestellt. Vorzugsweise handelt es sich bei der Wechselspannung um ein Rechtecksignal, welches relativ einfach zu erzeugen ist.

Die Meßaufgabe des AMR-Sensors 1 besteht darin, die Richtung des Magnetfeldes B, d.h. den Winkel $\alpha$, über einen Bereich von 0 bis 360° eindeutig zu bestimmen.

Der AMR-Sensor 1 liefert an seinen Ausgängen $C_1$, $C_2$ ein dem Winkel $\alpha$ zuordenbares sinusförmiges Signal, und an seinen Ausgängen $S_1$, $S_2$ ein dem Winkel $\alpha$ zuordenbares cosinusförmiges Signal. Diese Signale werden zunächst in Differenzverstärkern 4 bzw. 5 verstärkt.

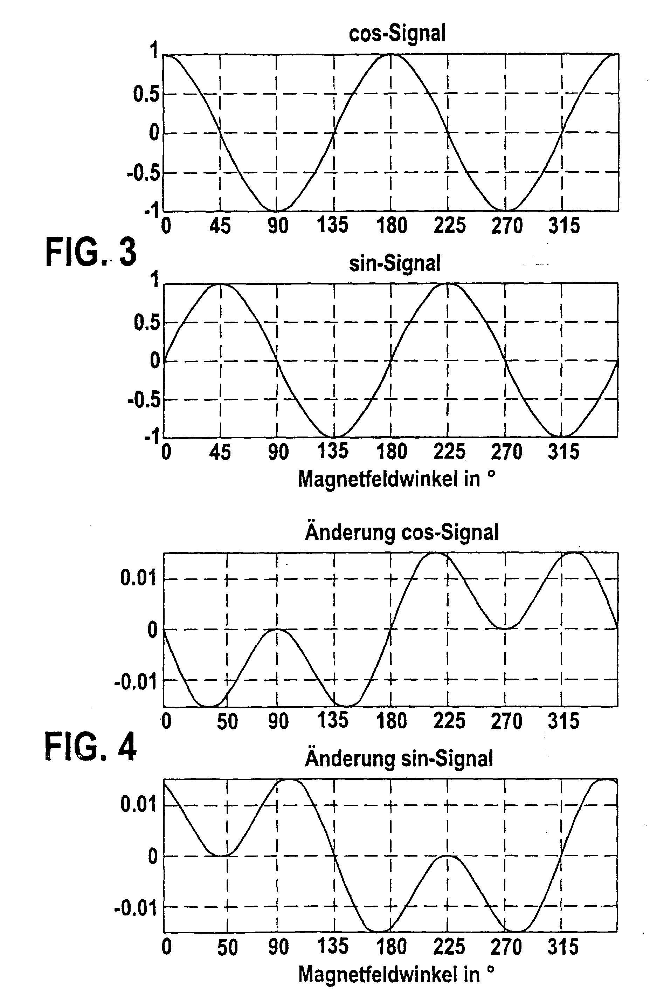

Nach Abzug eventuell vorhandener Offsetspannungen in Subtraktionsgliedern 6 bzw. 7 stehen Signale der Form Acos($2\alpha$) und Asin($2\alpha$) zur Verfügung. Hierbei stellt A die temperaturabhängige Amplitude des Signals dar. Derartige Signale sind zur Veranschaulichung in Figur 3 dargestellt.

Die Ausgangssignale der Differenzverstärker 4, 5 stellen erste und zweite Signale dar, welche dem magnetischen Gesamtfeld, welches sich aus dem äußeren, zu messenden magnetischen Feld und dem durch die Hilfsspulen erzeugten magnetischen Feld zusammensetzt.

Hierbei spielen die relativ geringen Fluktuationen dieser ersten und zweiten Signale, die durch das fluktuierende Magnetfeld verursacht werden, für eine zunächst durchgeführte Winkelauswertung in einer Winkelauswertungseinheit 8 keine Rolle bzw. können vernachlässigt werden. Dies liegt zum einen daran, daß die auftretenden Fluktuationen bei einer Winkelberechnung in der Einheit 8 ausgemittelt werden können, und ferner daran, daß weiter unten im einzelnen beschriebene Kondensatoren bezüglich des fluktuierenden Anteils des ersten und zweiten Signals als Hochpaßfilter wirken, über welche die Fluktuationen der ersten und zweiten Signale ausgekoppelt werden können.

Die Winkelauswertungseinheit 8 bestimmt zunächst den nicht korrigierten Winkel $\alpha$, welcher nur im Bereich von 0 bis 180° eindeutig bestimmt ist. Dies kann beispielsweise durch Bildung des Arcustangens erfolgen, insbesondere nach der Formel

$$\alpha = 0{,}5 *\arctan([A * \sin (2 * \alpha)]/[A * \cos((2 * \alpha)]).$$

Das erste und das zweite Signal werden ferner zwei Komparatoren 12, 13 zugeführt. Das Logik-Ausgangssignal K1 des Komparators 12 ist dann = 1, wenn das dritte Signal (cos-Signal) $\geq$ 0 ist. Das Signal K2 (Logik-Ausgangssignal des Komparators 13) ist dann = 1, wenn das vierte Signal (sin-Signal) < 0 ist. Die Signale K1, K2 werden anschließend einem UND-Glied 14 zugeführt.

Die von dem Wechselstrom in der Hilfsspule verursachten geringen Fluktuationen des ersten und zweiten Signals werden über die bereits erwähnten Kondensatoren 10, 11 ausgekoppelt und zu zwei Synchron-Demodulatoren 16, 17 mit jeweils nachgeschalteten Tiefpässen 18, 19 geführt. Die Synchron-Demodulatoren polen im Takt des Generatorsignals des Generators 3 das jeweilige Eingangssignal periodisch um. Es ergibt sich eine phasensensitive Gleichrichtung des Wechselanteils. An den Ausgängen der Tiefpässe sind die in Figur 4 dargestellten Signale "Änderung-cos-Signal" bzw. "Änderung-sin-Signal" direkt zu beobachten.

Zwei weitere Komparatoren 20, 21 bilden aus diesen Signalen weitere Logik-Signale K3 und K4. Das Signal K3 = 1, wenn die Summe aus Sinus-Änderungssignal und Cosinus-Änderungssignal $\geq 0$ ist, das Signal K4 =1, wenn die Differenz aus Sinus-Änderungssignal und Cosinus-Änderungssignal $\geq 0$ ist.

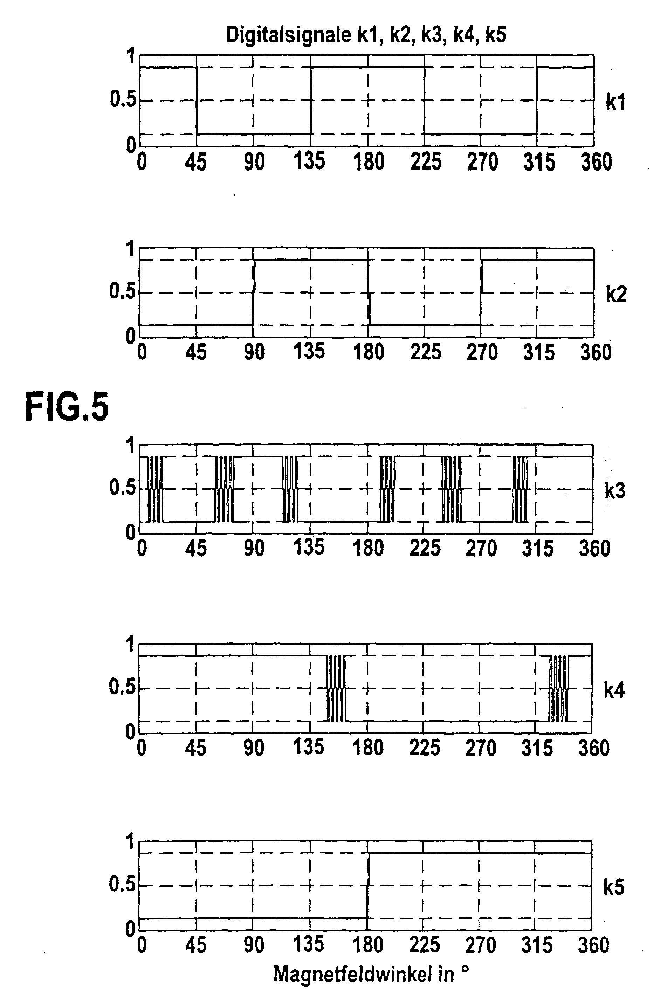

Die Logik- bzw. Digitalsignale K1 bis K4 sind in Figur 5 in den ersten vier Zeilen in Abhängigkeit von einem jeweiligen Winkel des äußeren Magnetfeldes aufgezeichnet.

Aus den Logik-Signalen K1 bis K4 wird nun mittels des bereits erwähnten UND-Gliedes 14, eines ODER-Gliedes 24 und zweier NAND-Glieder 25, 26 in der dargestellten Weise ein weiteres Logik-Signal K5 durch logische Kombination gebildet. Das Signal K5 soll im Bereich 0 bis 180° = 0, im Bereich ab 180 bis 360° = 1 sein. Das Signal K5 ist in Figur 5, unterste Zeile dargestellt.

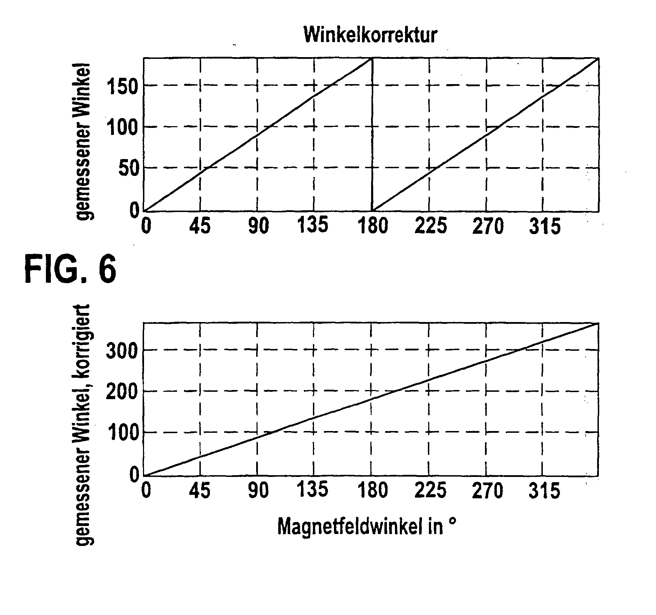

Das Logik-Signal K5 wird zusammen mit dem in der Winkelauswerteeinheit 8 erhaltenen fünften Signal einer Auswerte- und Addiereinheit 30 zugeführt. Für den Fall, daß $\alpha$ den Wert 1 einnimmt, wird in diesem Element 30 dem Ausgangssignal der Winkelauswerteeinheit 8 ein Korrekturwinkel von 180° hinzuaddiert, so daß auf der Grundlage eines unkorrigierten Winkelwertes, welcher eine Periodizität von 180° aufweist, ein korrigierter Winkelwert mit Periodizität von 360° bereitstellbar ist. Dies wird anhand der Figur 6 deutlich, in welcher oben der unkorrigierte Winkel, und unten der korrigierte gemessene Winkel in Abhängigkeit von einem tatsächlichen Winkel des äußeren Magnetfeldes dargestellt sind.

Es sei angemerkt, daß in der Figur 5 bezüglich der Logik-Signale K3, K4 Winkelbereiche festgestellt wurden, welche durch einen häufigen 0-1-Wechsel gekennzeichnet sind. In diesen Bereichen kann keine eindeutige Aussage über das Vorzeichen des entsprechenden Eingangssignals gemacht werden, da das Eingangssignal dort sehr klein ist und beispielsweise Offset-Spannungen der Komparatoren oder Rauschsignale u.U. zu verfälschten Informationen führen können.

Die gemäß Figur 1 realisierte Logik zur Berechnung des Korrekturwertes K5 nimmt hierauf Rücksicht. Die Signale K3 und K4 werden nur in den Winkelbereichen zur Ermittlung von K5 bestimmt, in denen sie jeweils "sicher" bestimmt werden können.

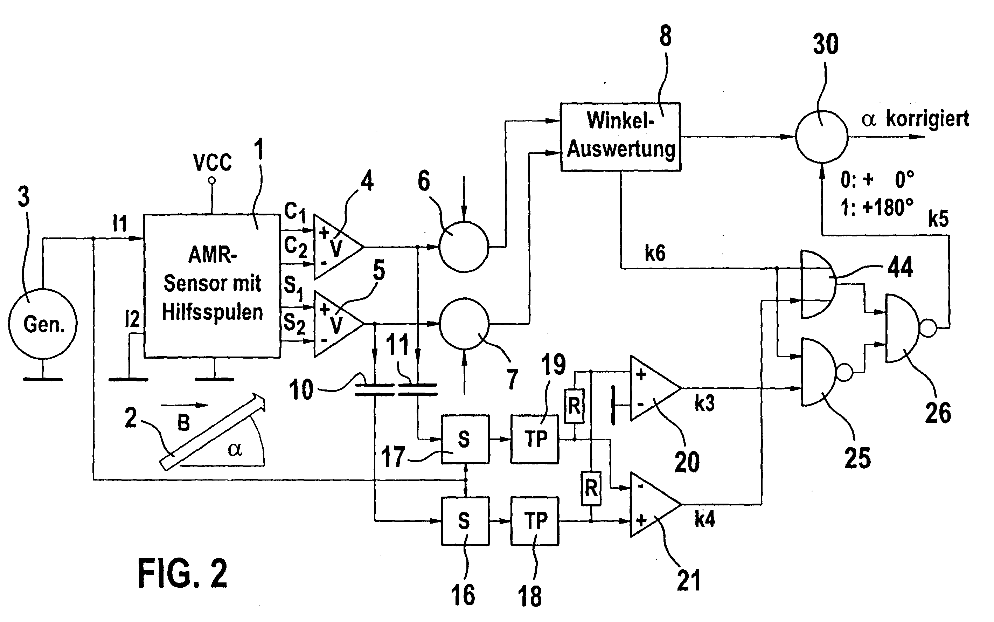

In Figur 2 ist eine Modifikation der Schaltung der Figur 1 dargestellt. Gleiche bzw. entsprechende Bauteile sind mit gleichen Bezugszeichen wie in Figur 1 versehen.

Die Ausführungsform der Figur 2 unterscheidet sich von derjenigen der Figur 1 dadurch, daß ein Logiksignal K6 von der Winkelauswerteeinheit 8 direkt auf ein ODER-Glied 44 gegeben wird. K6 ist hierbei = 1, wenn der gemessene unkorrigierte Winkel $\alpha$ im Bereich 135 bis < 180° liegt. Durch diese Maßnahme ist es im Vergleich zur Schaltung der Figur 1 möglich, auf zwei Komparatoren und ein UND-Glied zu verzichten und dennoch ein entsprechendes Logiksignal K5 zur Verfügung zu stellen. Es ist in diesem Zusammenhang insbesondere darauf hinzuweisen, daß hierdurch auch der Einfluß der Offset-Spannungen der beiden entfallenden Komparatoren eliminiert wird.

**Patentansprüche**

1. Verfahren zur Feststellung der Richtung eines äußeren Magnetfeldes (B) unter Verwendung eines magneto-resitiven Sensors, mit folgenden Schritten:

   - Überlagerung des äußeren Magnetfeldes (B) mit einem fluktuierenden Magnetfeld,
   - Erzeugung eines vom Sinus und Cosinus des Winkels ($\alpha$) des äußeren Magnetfeldes bezüglich einer Referenzrichtung abhängigen ersten bzw. zweiten Signals unter Auskopplung oder Vernachlässigung jeweiliger vom fluktuierenden Magnetfeld abhängiger Signalanteile,
   - Ermittlung eines dem Winkel ($\alpha$) des äußeren magnetischen Feldes bezüglich der Referenzrichtung zuordenbaren dritten Signals auf der Grundlage des ersten und des zweiten Signals, wobei dieses dritte Signal eine Periodizität von 180° aufweist,
   - Ermittlung eines Korrektur-Logik-Signals (K5) unter Berücksichtigung der aus dem ersten bzw. zweiten Signal ausgekoppelten, vom fluktuierenden Magnetfeld abhängigen Signalanteils, welches für einen Winkel des äußeren Magnetfeldes (B) in einem ersten Winkelbereich, insbesondere zwischen 0° und 180°, einen ersten Pegel, und in einem zweiten Winkelbereich, insbesondere zwischen 180° und 360° einen zweiten Pegel einnimmt, und
   - Ermittlung des tatsächlichen Winkels des Magnetfeldes (B) auf der Grundlage des Korrektur-Logik-signals (K5) und des dritten Signals.

2. Verfahren nach Anspruch 1, **dadurch gekennzeichnet, daß** zur Ermittlung des korrektur-Logik-Signals (K5) zusätzlich das erste und das zweite Signal berücksichtigt werden.

3. Verfahren nach Anspruch 1, **dadurch gekennzeichnet, daß** zur Ermittlung des korrektur-Logik-Signals ein weiteres digitales Signal (K6) verwendet wird, welches in Abhängigkeit von einem dem dritten Signal zuordenbaren Winkel einen ersten oder zweiten Pegel einnimmt.

4. Verfahren nach Anspruch 3, **dadurch gekennzeichnet, daß** das weitere digitale signal (K6) für einen Winkelbereich von 135° bis 180° einen ersten Pegel, und einen Winkelbereich zwischen 0° und 135° einen zweiten Pegel einnimmt.

5. Schaltungsanordnung zur Feststellung der Richtung eines äußeren Magnetfeldes B mit

- Mitteln (3) zur Überlagerung des äußeren Magnetfeldes (B) mit einem fluktuierenden Magnetfeld,
- Mitteln (1, 4, 5) zur Erzeugung eines vom Sinus und Cosinus des Winkels (α) des äußeren Magnetfeldes (B) bezüglich einer Referenzrichtung abhängigen ersten bzw. zweiten Signals unter Auskopplung oder Vernachlässigung jeweiliger vom fluktuierenden Magnetfeld abhängiger Signalanteile,
- Mitteln (8) zur Ermittlung eines dem Winkel des äußeren magnetischen Feldes (B) bezüglich der Referenzrichtung zuordenbaren dritten Signals auf der Grundlage des ersten und des zweiten Signals, wobei dieses dritte Signal eine Periodizität von 180° aufweist,
- Mitteln (10, 11, 16, 17, 18, 19, 20, 21, 12, 13, 14, 24, 25, 26) zur Ermittlung eines Korrektur-Logik-Signals (K5) unter Berücksichtigung des aus dem ersten bzw. zweiten Signal ausgekoppelten, vom fluktuierenden Magnetfeld abhängigen Signalanteils, welches für einen Winkel des äußeren Magnetfeldes (B) in einem ersten Winkelbereich, insbesondere zwischen 0° und 180°, einen ersten Pegel, und in einem zweiten Winkelbereich, insbesondere zwischen 180° und 360°, einen zweiten Pegel einnimmt, und
- Mitteln (30) zur Ermittlung des tatsächlichen Winkels des Magnetfeldes (B) auf der Grundlage des Korrektur-Logik-Signals (K5) und des dritten Signals.

6. Schaltungsanordnung nach Anspruch 5, **gekennzeichnet durch** Mittel (8) zur Erzeugung eines weiteren Logiksignals (K6) welches in Abhängigkeit von einem dem dritten Signal zuordenbaren Winkel einen ersten oder zweiten Pegel einnimmt.

**Claims**

1. Method for determining the direction of an external magnetic field (B) using a magnetoresistive sensor, having the following steps:

- a fluctuating magnetic field is superimposed on the external magnetic field (B),

- a first and a second signal which are dependent on the sine and cosine of the angle (α) of the external magnetic field with respect to a reference direction are produced, with respective signal components which are dependent on the fluctuating magnetic field being extracted or ignored,
- a third signal which can be associated with the angle (α) of the external magnetic field with respect to the reference direction is determined on the basis of the first and second signals, with this third signal having a periodicity of 180°,
- a correction logic signal (K5) is determined taking into account the signal component which has been extracted from the first and second signals and is dependent on the fluctuating magnetic field, with said correction logic signal assuming a first level for an angle of the external magnetic field (B) in a first angle range, in particular between 0° and 180°, and assuming a second level in a second angle range, in particular between 180° and 360°, and
- the actual angle of the magnetic field (B) is determined on the basis of the correction logic signal (K5) and the third signal.

2. Method according to Claim 1, **characterized in that** the first and second signals are additionally taken into account for the purpose of determining the correction logic signal (K5).

3. Method according to Claim 1, **characterized in that** a further digital signal (K6), which assumes a first or a second level as a function of an angle which can be associated with the third signal, is used to determine the correction logic signal.

4. Method according to Claim 3, **characterized in that** the further digital signal (K6) assumes a first level for an angle range of 135° to 180° and assumes a second level for an angle range of between 0° and 135°.

5. Circuit arrangement for determining the direction of an external magnetic field B, having

- means (3) for superimposing a fluctuating magnetic field on the external magnetic field (B),
- means (1, 4, 5) for producing a first and a second signal which are dependent on the sine and cosine of the angle (α) of the external magnetic field (B) with respect to a reference direction, with respective signal components which are dependent on the fluctuating magnetic field being extracted or ignored,
- means (8) for determining a third signal, which can be associated with the angle of the external magnetic field (B) with respect to the reference direction, on the basis of the first and second signals, with this third signal having a periodicity of 180°,

- means (10, 11, 16, 17, 18, 19, 20, 21, 12, 13, 14, 24, 25, 26) for determining a correction logic signal (K5) taking into account the signal component which has been extracted from the first and second signals and is dependent on the fluctuating magnetic field, with said correction logic signal assuming a first level for an angle of the external magnetic field (B) in a first angle range, in particular between 0° and 180°, and assuming a second level in a second angle range, in particular between 180° and 360°, and

- means (30) for determining the actual angle of the magnetic field (B) on the basis of the correction logic signal (K5) and the third signal.

6. Circuit arrangement according to Claim 5, **characterized by** means (8) for producing a further logic signal (K6) which assumes a first or a second level as a function of an angle which can be associated with the third signal.

## Revendications

1. Procédé de détermination de la direction d'un champ magnétique extérieur (B) en utilisant un capteur magnétorésistif, comportant les étapes suivantes :

   - superposition du champ magnétique extérieur (B) avec un champ magnétique fluctuant,

   - génération d'un premier ou d'un deuxième signal dépendant du sinus et du cosinus de l'angle ($\alpha$) du champ magnétique extérieur par rapport à une direction de référence, en découplant ou en négligeant certaines parties de signal dépendant du champ magnétique fluctuant,

   - détermination d'un troisième signal pouvant être associé à l'angle du champ magnétique extérieur par rapport à la direction de référence, sur la base du premier et du deuxième signal, ce troisième signal présentant une périodicité de 180°,

   - détermination d'un signal logique de correction (K5) en prenant en compte la partie de signal découplée du premier ou du deuxième signal et dépendant du champ magnétique fluctuant, qui prend, pour un angle du champ magnétique extérieur (B), dans une première zone angulaire, en particulier comprise entre 0° et 180°, un premier niveau, tandis qu'il prend, dans une deuxième zone angulaire, en particulier comprise entre 180° et 360°, un deuxième niveau, et

   - détermination de l'angle effectif du champ magnétique (B) sur la base du signal logique de correction (K5) et du troisième signal.

2. Procédé selon la revendication 1, **caractérisé en ce que** pour la détermination du signal logique de correction (K5), on prend également en compte le premier et le deuxième signal.

3. Procédé selon la revendication 1, **caractérisé en ce que** pour la détermination du signal logique de correction (K5), on utilise un autre signal numérique (K6), qui prend en fonction d'un angle pouvant être associé au troisième signal un premier ou un deuxième niveau.

4. Procédé selon la revendication 3, **caractérisé en ce que** l'autre signal numérique (K6) prend, pour une première zone angulaire comprise entre 135° et 180°, un premier niveau, et pour une zone angulaire comprise entre 0° et 135°, un deuxième niveau.

5. Circuit pour la détermination de la direction d'un champ magnétique extérieur B, comportant :

   - des moyens (3) permettant de superposer le champ magnétique extérieur (B) avec un champ magnétique fluctuant,

   - des moyens (1, 4, 5) permettant de générer un premier ou un deuxième signal dépendant du sinus et du cosinus de l'angle ($\alpha$) du champ magnétique extérieur (B) par rapport à une direction de référence, en découplant ou en négligeant certaines parties de signal dépendant du champ magnétique fluctuant,

   - des moyens (8) permettant de déterminer un troisième signal pouvant être associé à l'angle du champ magnétique extérieur (B) par rapport à la direction de référence, sur la base du premier et du deuxième signal, ce troisième signal présentant une périodicité de 180°,

   - des moyens (10, 11, 16, 17, 18, 19, 20, 21, 12, 13, 14, 24, 25, 26) permettant de déterminer un signal logique de correction (K5) en prenant en compte la partie de signal découplée du premier ou du deuxième signal et dépendant du champ magnétique fluctuant, qui prend, pour un angle du champ magnétique extérieur (B), dans une première zone angulaire, en particulier comprise entre 0° et 180°, un premier niveau, tandis qu'il prend, dans une deuxième zone angulaire, en particulier comprise entre 180° et 360°, un deuxième niveau, et

   - des moyens (30) permettant de déterminer l'angle effectif du champ magnétique (B) sur la base du signal logique de correction (K5) et du troisième signal.

6. Circuit selon la revendication 5, **caractérisé par** des moyens (8) permettant de générer un autre signal logique (K6) qui prend, en fonction d'un angle pouvant être associé au troisième signal, un premier ou un deuxième niveau.

FIG. 1

FIG. 2

**FIG. 3**

cos-Signal

sin-Signal

Magnetfeldwinkel in °

**FIG. 4**

Änderung cos-Signal

Änderung sin-Signal

Magnetfeldwinkel in °

## Digitalsignale k1, k2, k3, k4, k5

**FIG.5**

Magnetfeldwinkel in °

Winkelkorrektur

FIG. 6

Magnetfeldwinkel in °